# EUROPEAN PATENT APPLICATION

(11) **EP 4 160 670 A1**
(43) Date of publication of application: **05.04.2023**
(21) Application number: 21813886.5
(22) Date of filing: 27.05.2021
(51) Int. Cl.: H01L 23/373, B23K 20/00, H01L 21/02, H01L 23/36, H01L 29/16

(54) **DIAMOND COMPOSITE AND PRODUCTION METHOD THEREFOR**

(30) Priority: 29.05.2020 JP 2020094917; 19.11.2020 JP 2020192739
(71) Applicant: National Institute Of Advanced Industrial Science and Technology, Chiyoda-ku Tokyo 100-8921 (JP)
(72) Inventor: MATSUMAE, Takashi, Tsukuba-shi, Ibaraki 305-8560 (JP); UMEZAWA, Hitoshi, Ikeda-shi, Osaka 563-8577 (JP); KURASHIMA, Yuuichi, Tsukuba-shi, Ibaraki 305-8560 (JP); TAKAGI, Hideki, Tsukuba-shi, Ibaraki 305-8560 (JP)
(74) Representative: V.O.
(86) International application number: PCT/JP2021/020210
(87) International publication number: WO 2021/241691

(57) **Abstract**

This diamond composite (100) includes a first base substrate (10) which has an oxide layer (10a) of element M and contains the element M in the composition and a second base substrate (20) which is bonded to the oxide layer (10a) and is composed of diamond, in which the M is one or more selected from a metal element (where alkali metals and alkaline earth metals are excluded) with which an oxide can be formed, Si, Ge, As, Se, Sb, Te, and Bi, and the second base substrate (20) is bonded to the oxide layer (10a) of the first base substrate (10) by M-O-C bonding of at least some C atoms on the (100) surface of the diamond constituting the second base substrate (20).

## Description

### TECHNICAL FIELD

The present invention relates to a diamond composite having a base substrate composed of diamond, a method of manufacturing a diamond composite.

Priority is claimed on Japanese Patent Application No. 2020-094917, filed May 29, 2020, and Japanese Patent Application No. 2020-192739, filed November 19, 2020, the contents of which are incorporated herein by reference.

### BACKGROUND ART

Diamond has extremely high thermal conductivity and dielectric breakdown electric field. By directly bonding an existing device to the diamond substrate, a significant improvement in cooling efficiency and input/output power can be expected.

A method is known in which a diamond substrate and a Si substrate are thermocompression bonded at a temperature of 1000 °C or higher and a pressure of 32 MPa to directly bond them at the atomic level (Non Patent Literature 1).

Furthermore, a method is also known in which an atomic level flat diamond substrate and a quartz glass are brought into contact with each other, heated to a temperature of 800 °C to 900 °C in a hydrogen atmosphere, and then the diamond and the quartz are directly bonded (Non Patent Literature 2).

Furthermore, a method is also known in which dangling bonds are exposed on the surface (100) of diamond substrate and the surface of Si substrate by surface sputtering with an Ar atom beam in a vacuum, and the surfaces are brought into contact and directly bonded at room temperature (Non Patent Literature 3). Furthermore, a method is also known in which dangling bonds are exposed on the surface of polycrystalline diamond substrate and the surface of A1 substrate by surface sputtering with an Ar atom beam in a vacuum, and the surfaces are brought into contact and directly bonded at room temperature (Non Patent Literature 4).

### CITATION LIST

### Non Patent Literature

Non Patent Literature 1: G. N. Yushin et al., Appl. Phys. Lett., 81, 3275-3277 (2002)
Non Patent Literature 2: J. Haisma, B. A. C. M. Spierings, U. K. P. Biermann and A. A. van Gorkum, Appl. Opt., 33, 1154 (1994)
Non Patent Literature 3: J. Liang, S. Masuya, M. Kasu, and N. Shigekawa, Appl. Phys. Lett., 110, 111603 (2017) http://aip.scitation.org/doi/10.1063/1.4978666.
Non Patent Literature 4: J. Liang, S.Yamajo, M. Kuball, and N. Shigekawa, Scripta Materialia, 159, 58-61, (2019)

### SUMMARY OF INVENTION

### Problems to be Solved by the Invention

However, the composite of diamond and Si bonded by the method in Non Patent Literature 1 may break during cooling due to stress caused by the difference in the coefficient of thermal expansion.

Although the method described in the Non Patent Literature 2 can be used for bonding without any bonding load, it requires treatment under a hydrogen atmosphere and at a high temperature, and the advent of technology for bonding diamond to a base substrate under mild conditions is desired.

In principle, the methods of Non Patent Literatures 3 and 4 need to be carried out in an ultrahigh vacuum atmosphere, and cannot be carried out withput using a dedicated vacuum bonding machine. In addition, there is a problem that surface sputtering makes the diamond surface amorphous and deteriorates mechanical, thermal and electrical properties.

In addition, single crystal diamond substrates with various crystal surfaces on the surface thereof are commercially available. Substrates with (100) surfaces have an advantage in size and cost reduction and should be utilized. In addition, large substrates of polycrystalline diamond, which are relatively inexpensive, are commercially available, and direct bonding applications are required.

In view of such circumstances, the present invention has been made to provide a diamond composite containing a diamond (100) substrate, a diamond composite containing a polycrystalline diamond substrate, an electronic device using them, and a manufacturing method of the diamond composite.

### Means for Solving the Problems

In order to solve the above problems, the present invention provides the following means.
(1) A diamond composite according to a first aspect of the present invention includes a first base substrate which has an oxide layer MOx of element M on the surface thereof and contains the element M in the composition, and a second base substrate which is bonded to the oxide layer and is composed of diamond, wherein the M is one or more selected from a metal element (where alkali metals and alkaline earth metals are excluded) with which an oxide can be formed, Si, Ge, As, Se, Sb, Te, and Bi, and the second base substrate is bonded to the oxide layer of the first base substrate by M-O-C bonding of at least some C atoms on the (100) surface of the diamond constituting the second base substrate.
(2) In the diamond composite according to the above aspect, the M may be one or more selected from Si, Ti, Al, Cu, In and Ga.
(3) In the diamond composite according to the above aspect, the first base substrate may be a heat sink or a heat spreader.
(4) An electronic device according to a second aspect of the present invention includes the diamond composite according to the above aspect, wherein the (100) surface of the diamond constituting the second base substrate is bonded to the oxide layer of the first base substrate, and an electronic element is formed on the other surface of the second base substrate, which is not bonded to first base substrate.
(5) An electronic device according to a third aspect of the present invention includes the diamond composite according to the above aspect, wherein the oxide layer of the first base substrate is bonded to the (100) surface of the diamond constituting the second base substrate, and an electronic element is formed on the other surface of the first base substrate, which is not bonded to second base substrate.
(6) A diamond composite according to a fourth aspect of the present invention includes a first base substrate which has an oxide layer MOx of element M on the surface thereof and contains the element M in the composition, and a second base substrate which is bonded to the oxide layer and is composed of polycrystalline diamond, wherein the M is one or more selected from a metal element (where alkali metals and alkaline earth metals are excluded) with which an oxide can be formed, Si, Ge, As, Se, Sb, Te, and Bi, and the second base substrate is bonded to the oxide layer of the first base substrate by M-O-C bonding of at least some C atoms on the surface of the polycrystalline diamond constituting the second base substrate.
(7) In the diamond composite according to the above aspect, the M may be one or more selected from Si, Ti, Al, Cu, In and Ga.
(8) In the diamond composite according to the above aspect, the first base substrate may be a heat sink or a heat spreader.
(9) An electronic device according to a fifth aspect of the present invention includes the diamond composite according to the above aspect, wherein the surface of the polycrystalline diamond constituting the second base substrate is bonded to the oxide layer of the first base substrate, and an electronic element is formed on the other surface of the second base substrate, which is not bonded to first base substrate.
(10) An electronic device according to a sixth aspect of the present invention includes the diamond composite according to the above aspect, wherein the oxide layer of the first base substrate is bonded to the surface of the polycrystalline diamond constituting the second base substrate, and an electronic element is formed on the other surface of the first base substrate, which is not bonded to second base substrate.
(11) A method for hydroxylating a surface of a base substrate composed of diamond according to a seventh aspect of the present invention includes treating a (100) surface or a (111) surface of the base substrate composed of diamond with a mixture of ammonia and hydrogen peroxide to introduce OH groups to at least some C atoms of the (100) surface or the (111) surface.
(12) A method for hydroxylating a surface of a base substrate composed of diamond according to an eighth aspect of the present invention includes treating a (100) surface or a (111) surface of the base substrate composed of diamond with a mixture of ammonia and hydrogen peroxide to introduce OH groups to at least some C atoms of the (100) surface or the (111) surface.
(13) A method of manufacturing a diamond composite according to a ninth aspect of the present invention includes a first hydroxylation step of introducing OH groups to at least part of a surface of an oxide layer of a first base substrate having the oxide layer MOx of element M on the surface thereof and containing the element M in the composition, a second hydroxylation step of treating a (100) surface or a (111) surface of a second base substrate composed of diamond with a mixture of ammonia and hydrogen peroxide to introduce OH groups to at least some C atoms of the (100) surface or the (111) surface, a contact step of contacting the surface of the first base substrate into which the OH groups are introduced with the (100) surface or the (111) surface of the diamond constituting the second base substrate into which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.
(14) A method of manufacturing a diamond composite according to a tenth aspect of the present invention includes a first hydroxylation step of introducing OH groups to at least part of a surface of an oxide layer of a first base substrate having the oxide layer MOx of element M on the surface thereof and containing the element M in the composition, a second hydroxylation step of treating a surface of a second base substrate composed of polycrystalline diamond with a mixture of ammonia and hydrogen peroxide to introduce OH groups to at least some C atoms of the surface, a contact step of contacting the surface of the first base substrate into which the OH groups are introduced with the surface of the polycrystalline diamond constituting the second base substrate into which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.
(15) A method of manufacturing a diamond composite according to a eleventh aspect of the present invention includes a first hydroxylation step of treating a surface of an oxide layer of a first base substrate having the oxide layer MOx of element M on the surface thereof and containing the element M in the composition with a mixture of ammonia and hydrogen peroxide to introduce OH groups to at least part of the surface, a second hydroxylation step of treating a (100) surface or a (111) surface of a second base substrate composed of diamond with an oxidizing liquid to introduce OH groups to at least some C atoms of the (100) surface or the (111) surface, a contact step of contacting the surface of the first base substrate into which the OH groups are introduced with the (100) surface or the (111) surface of the diamond constituting the second base substrate into which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.
(16) A method of manufacturing a diamond composite according to a twelfth aspect of the present invention includes a first hydroxylation step of treating a surface of an oxide layer of a first base substrate having the oxide layer MOx of element M on the surface thereof and containing the element M in the composition with a mixture of ammonia and hydrogen peroxide to introduce OH groups to at least part of the surface, a second hydroxylation step of treating a surface of a second base substrate composed of polycrystalline diamond with an oxidizing liquid to introduce OH groups to at least some C atoms of the surface, a contact step of contacting the surface of the first base substrate into which the OH groups are introduced with the surface of the polycrystalline diamond constituting the second base substrate into which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.

### Effects of the Invention

According to the diamond composite of the present invention, a diamond composite containing a diamond (100) substrate can be provided.

According to the diamond composite of the present invention, a diamond composite containing a polycrystalline diamond substrate can be provided.

### BRIEF DESCRIPTION OF THE DRAWINGS

FIG. 1(a) is a schematic cross-sectional view showing the diamond composite of the present invention, and Fig. 1(b) is a diagram schematically shows the bonding state near the bonding interface of the first base substrate and the second base substrate composed of diamond on an atomic scale.
FIG. 2 is cross-sectional transmission electron microscope (TEM) images near the bonding interface of the diamond composite of the present invention, where (a) was obtained in a mode to enhance the atomic image of the Si substrate and (b) was obtained in a mode to enhance the atomic image of diamond.
FIG. 3 is a schematic cross-sectional view of a diamond device that is an electronic device according to one embodiment of the present invention.
FIG. 4 is a schematic cross-sectional view of an electronic device according to one embodiment of the present invention.
FIG. 5 are schematic perspective diagrams for illustrating the bonding method of the first base substrate and the second base substrate consisting of diamond used in the manufacturing method of the diamond composite according to the first embodiment of the present invention, where (a) is a hydroxylation step, (b) is a step of contacting the first and second base substrates, and (c) is a dehydration step.
FIG. 6 are schematic perspective diagrams for illustrating the bonding method of the first base substrate and the second base substrate consisting of diamond used in the manufacturing method of the diamond composite according to the second embodiment of the present invention, where (a) is a hydroxylation step, (b) is a step of contacting the first and second base substrates, and (c) is a dehydration step.
FIG. 7 are observation results of Newton rings in diamond composites (a) in Example 1, (b) in Example 2, and (c) in Comparative Example 1.
FIG. 8 are observation results of Newton rings in diamond composites (a) in Experimental Example 1, and (b) in Experimental Example 2.
FIG. 9 shows the measurement results of shear strength of diamond composites.
FIG. 10 shows the results of XPS measurements in the vicinity of the S₂ₚ energy on the (111) surfaces of diamond substrates after treatment with a mixture of ammonia and hydrogen peroxide and after treatment with a mixture of sulfuric acid and hydrogen peroxide in Experimental Example 1 and Experimental Example 2, respectively.
FIG. 11 shows the result of XPS measurement in the vicinity of the Nis energy for Experimental Example 1 shown in Fig. 10.
FIG. 12 shows the results of observing Newton rings for the diamond composites obtained in Experimental 4 and Experimental 5, (a) the result of Experimental 4, and (b) the result of Experimental 5.
FIG. 13 are schematic perspective diagrams for illustrating the bonding method of the first base substrate and the second base substrate consisting of diamond used in the manufacturing method of the diamond composite according to the third embodiment of the present invention, where (a) is a hydroxylation step, (b) is a step of contacting the first and second base substrates, and (c) is a dehydration step.
FIG. 14 are schematic perspective diagrams for illustrating the bonding method of the first base substrate and the second base substrate consisting of diamond used in the manufacturing method of the diamond composite according to the fourth embodiment of the present invention, where (a) is a hydroxylation step, (b) is a step of contacting the first and second base substrates, and (c) is a dehydration step.
FIG. 15 is an observation result of Newton rings in diamond composite obtained in Example 3.
FIG. 16 is an observation result of optical microscopy of the non-bonded part (lower right in Fig. 15) of diamond composite obtained in Example 3.
FIG. 17 is an observation result of optical microscopy of the non-bonded part (lower right in Fig. 15) of diamond composite obtained in Example 4.

### EMBODIMENTS FOR CARRYING OUT THE INVENTION

Embodiments of the present invention will be described below with reference to figures. In the following examples, parts that are identical or equal to each other may be designated by the same symbol in the figure. In addition, the drawings used in the following descriptions are sometimes enlarged to show the features for convenience, and the proportions of the dimensions of each component are not necessarily the same as in reality. In addition, the materials, dimensions, etc., exemplified in the following description are examples, and the present invention is not limited to them, and it is possible to carry out the invention with appropriate modifications to the extent that the effect of the present invention is achieved. The configuration shown in one embodiment can also be applied to the other.

### (Diamond Composite (First Embodiment))

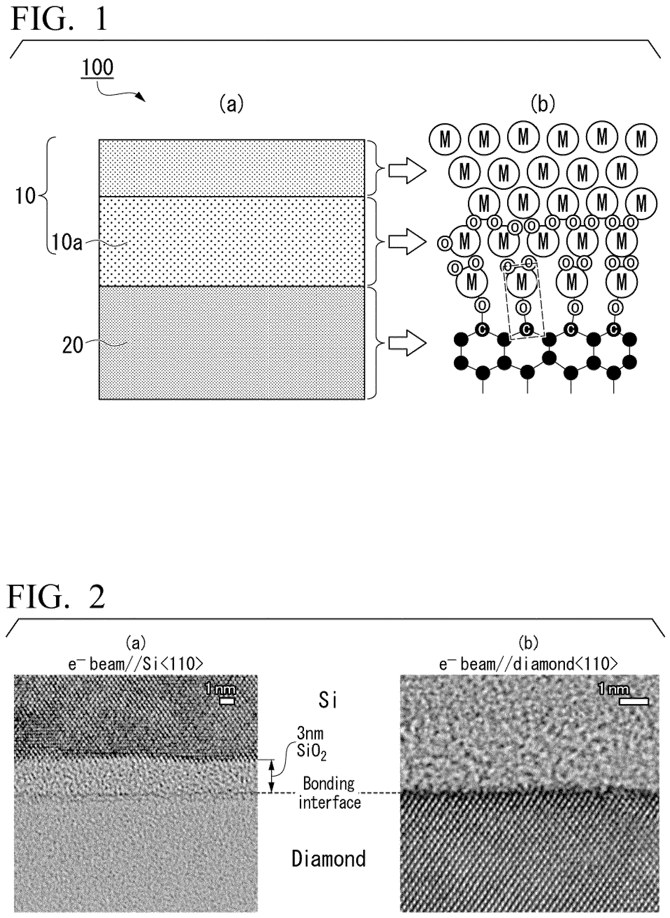

Fig. 1 (a) is a schematic cross-sectional view showing a diamond composite according to the first embodiment of the present invention. Fig. 1 (b) is a schematic diagram of the bonding state near the bonding interface of the first base substrate and the second base substrate consisting of diamond on an atomic scale.

Figure 2 shows a cross-sectional TEM image of the vicinity of the bonding interface between the Si substrate and the diamond (100) surface constituting the second base substrate, using the Si substrate as the first base substrate, with (a) obtained in a mode that emphasizes the atomic image of the Si substrate and (b) obtained in a mode that emphasizes the atomic image of the diamond. This cross-sectional TEM image is a cross-sectional TEM image of the diamond composite obtained in Example 2, which will be described later.

The diamond composite 100 shown in Fig. 1 (a) includes a first base substrate 10 which has an oxide layer 10a of element M and contains the element M in the composition and a second base substrate 20 which is bonded to the oxide layer 10a and is composed of diamond, in which the M is one or more selected from a metal element (where alkali metals and alkaline earth metals are excluded) with which an oxide can be formed, Si, Ge, As, Se, Sb, Te, and Bi, and the second base substrate 20 is bonded to the oxide layer 10a of the first base substrate 10 by M-O-C bonding of at least some C atoms on the (100) surface of the diamond constituting the second base substrate 20.

The formation of the M-O-C bond can be confirmed, for example, by Fourier transform infrared spectroscopy (FT-IR).

The cross-sectional TEM image near the bonding interface shown in Fig. 2 shows that they are bonded at the (100) surface of the diamond.

The first base substrate 10 is a base substrate which has an oxide layer 10a of element M on the surface thereof and contains the element M in the composition. Such a base substrate may be a base substrate consisting mainly of element M or M compound and having a thermal oxide film or natural oxide film MOx formed on the surface thereof, or a base substrate consisting mainly of MOx or composed of MOx. The base substrate composed mainly of element M or M compound with thermal oxide film or natural oxide film MOx formed on the surface thereof includes Si substrate, SiC substrate, SiN substrate, Ge substrate, GaAs substrate, GaN substrate, InP substrate, Cu substrate, Al substrate, AlN substrate, Ti substrate, TiN substrate or the like. The base substrate composed of MOx includes SiO₂ substrate, a Ga₂Oₛ substrate, an Al₂O₃ substrate, a CuO substrate, a TiO₂ substrate or the like. The base substrate may have a single crystal structure or a polycrystal structure.

As described above, element M is one or more selected from a metal element (where alkali metals and alkaline earth metals are excluded) with which an oxide can be formed, Si, Ge, As, Se, Sb, Te, and Bi. Such metallic elements are Al, Sc with atomic number 21 to Ga with atomic number 31, Y with atomic number 39 to Sn with atomic number 50, La with atomic number 57 to Ir with atomic number 77, Tl, and Pb. These elements M can at least form an oxide layer MOx on the surface. If the element M, which can form the oxide layer MOx, is used as a base substrate, MOx can be converted into the hydroxides M-OH by appropriate treatment. Then, as described later, this M-OH and C-OH on the (100) surface of the OH group-introduced diamond crystal (sometimes referred to simply as diamond) undergo dehydration.

The M is preferably one or more selected from Si, Ti, Al, Cu, In and Ga. This is because substrates with these oxide layers MOx on the surface thereof are more likely to bond with diamond due to the bonding of M-O-C (see Fig. 1 (b)) and C on at least a part of the (100) surface of the diamond crystal. Substrates containing Si, Ti, Al, Cu, In, or Ga are used in various fields, and this is because diamond properties can be imparted to the substrates used in these fields.

### <Second Base Substrate>

The second base substrate 20 is composed of diamond. The bonding surface of the second base substrate 20 with the first base substrate 10 is the (100) surface.

The second base substrate 20 may be composed of diamond with a (100) surface on the bonding surface. For example, the entire second base substrate 20 may be composed of single-crystal diamond, or only the surface layer having the (100) surface may be a single-crystal diamond thin film, and the layer or base substrate under it may be polycrystal diamond, homoepitaxial diamond, heteroepitaxial diamond, etc.

Also, single crystal diamond or a single crystal diamond layer on the surface may contain impurities to the extent that the effect of the present invention is exerted.

### (Applications of Diamond Composite)

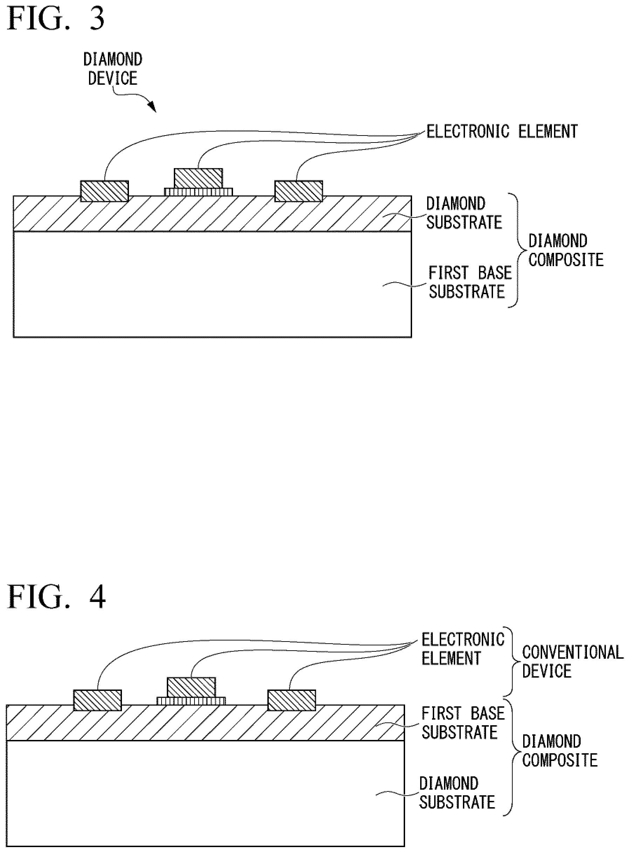

The diamond composite of the present embodiment can be applied to various fields. For example, it can be applied to electronic devices. The electronic device shown in Fig. 3 has a diamond composite according to the present embodiment, and the diamond crystal (diamond base substrate (second base substrate)) has a layered shape. One side of the diamond crystal is bonded to the surface of the first base substrate, and the other side of the diamond crystal is equipped with an electronic element.

The electronic device functions as a diamond device with electronic components such as semiconductor stacked structures, quantum devices, sensors, ultraviolet LEDs, or electron emission devices on a diamond crystal. By using the diamond composite of the present embodiment as a base substrate with an electronic element, only the surface layer of the inexpensive base substrate can be replaced with diamond crystals without making the entire base substrate an expensive diamond crystal. This allows the diamond device to cut costs. In the diamond composite of the present embodiment, such replacement is possible because the diamond crystal structure hardly changes near the bonding surface.

In addition, the other electronic device shown in Fig. 4 has a diamond composite of the present embodiment, and the first base substrate is plate-shaped. One side of the first base substrate is bonded to the surface of a diamond crystal (diamond base substrate (second base substrate)), and the other side of the first base substrate is equipped with an electronic element. The electronic device has a structure in which diamond crystals are bonded in the substrate of a conventional device. This allows the electronic device to efficiently dissipate heat generated by conventional devices toward diamond crystals. In addition, since diamond crystals have high breakdown field strength, high power can be input to the electronic components of this electronic device.

Moreover, if the first base substrate is used as an existing heat sink or heat spreader, the heat dissipation property of the diamond composite becomes high due to the high thermal conductivity of diamond. Thus, the diamond composite can be used as a new heat sink or heat spreader.

### (Diamond Composite (Second Embodiment))

A diamond composite according to the second embodiment of the present invention is similar to the diamond composite 100 in the diamond composite 100 according to the first embodiment shown in Fig. 1, except that the second base substrate 20 is composed of polycrystalline diamond.

When the diamond composite according to the second embodiment is explained using the diamond composite 100 shown in Fig. 1, the diamond composite 100 has an oxide layer 10 of element M on the surface, a first base substrate 10 containing element M in the composition, and a second base substrate 20 consisting of polycrystalline diamond bonded to the oxide layer 10a.

There are no particular restrictions on polycrystalline diamonds that can be used as polycrystalline diamonds constituting the second base substrate, and artificial polycrystalline diamonds produced by known production methods and natural polycrystalline diamonds can be used. As the artificial polycrystalline diamonds, for example, those produced by chemical vapor deposition (CVD) or high-temperature and high-pressure synthesis (HPHT) can be used.

Polycrystalline diamond may also contain impurities to the extent that the effect of the present invention is exerted.

There is no limit to the size of the grains constituting polycrystalline diamond, but, for example, grains of 1 µm to 1000 µm can be used.

The bonding surface of the second base substrate made of polycrystalline diamond with the first base substrate is preferably flattened by physical or chemical polishing before bonding.

The diamond composite according to the second embodiment can be used for the same application as the diamond composite according to the first embodiment.

### (Method of Manufacturing Diamond Composite (First Embodiment))

By a method for manufacturing a diamond composite according to one embodiment of the present invention, a diamond composite comprising a first base substrate and a second base substrate composed of diamond, and the diamond composite (the diamond composite according to the present invention described above) in which the first base substrate and the second base substrate are bonded on the (100) surface of diamond can be manufactured. In addition, by a method for manufacturing a diamond composite according to one embodiment of the present invention, a diamond composite comprising a first base substrate and a second base substrate composed of diamond, and the diamond composite can be manufactured in which the first base substrate and the second base substrate are bonded on the (111) surface of diamond can be manufactured.

In the diamond composite substrate bonded on the (111) surface of diamond manufactured by this manufacturing method, the first base substrate that can be used in the diamond composite bonded on the (100) surface of diamond (the diamond composite substrate according to the present invention described above) can be used. In addition, in the diamond composite substrate bonded at the (111) surface of the diamond manufactured by this manufacturing method, at least some of the C atoms of the (111) surface of the diamond constituting the second base substrate are bonded to the oxide layer of the first base substrate by M-O-C bonding.

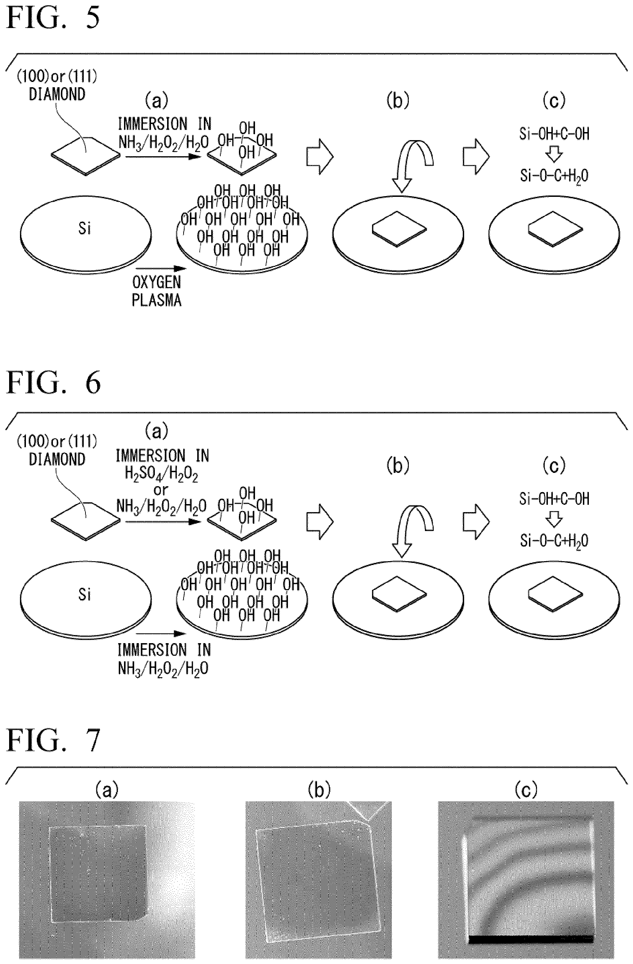

Fig. 5 (a) to Fig. 5 (c) are schematic perspective diagrams for explaining the bonding method between the first base substrate and the second base substrate made of diamond used in the method of manufacturing the diamond composite according to the present embodiment.

The method of bonding the first base substrate and the second base substrate made of diamond in the embodiment includes each hydroxylation step of each base material (Fig. 5 (a)) and a bonding step (Figures 5 (b) and (c)).

### < First Hydroxylation Step >

A first hydroxylation step is a step of introducing OH groups to at least part of a surface of an oxide layer of a first base substrate having the oxide layer MOx of element M on the surface thereof and containing the element M in the composition.

The oxide layer MOx of the first base substrate may be a natural oxide film formed naturally in the atmosphere or an oxide film formed by heating or the like.

The introduction of OH groups to at least part of the surface of the oxide layer of the first base substrate can be done by oxygen plasma irradiation. For example, if the first base substrate is a Si substrate, the first base substrate with Si-OH on the surface is obtained by irradiating the natural SiO₂ film or the thermal SiO₂ film with oxygen plasma.

### < Second Hydroxylation Step >

A second hydroxylation step is a step of treating a (100) surface or a (111) surface of a second base substrate composed of diamond with a mixture of ammonia and hydrogen peroxide (NH₃/H₂O₂/H₂O) to introduce OH groups to at least some C atoms of the (100) surface or the (111) surface of a second base substrate composed of diamond. This step is not limited to being performed using a mixture of ammonia and hydrogen peroxide (NH₃/H₂O₂/H₂O), but can be performed using an oxidizing liquid that generates less surface residue.

The second hydroxylation step can be carried out at a temperature between ordinary temperature and 80 °C. As shown in the examples, the same degree of bonding strength can be obtained both at room temperature and at 75 °C.

### <Bonding Step>

The bonding step includes a contact step (Fig. 5(b)) of contacting the surface of the first base substrate into which the OH groups are introduced with the (100) surface or the (111) surface of the diamond constituting the second base substrate into which the OH groups are introduced, and a dehydration step (Fig. 5(c)) of imparting activation energy to the contacted first and second base substrates to undergo dehydration.

The activation energy in this bonding step is small compared with the methods in Non Patent Literatures 1 and 2, and the bonding can be achieved by heating at about 200 °C.

As shown in Fig. 5 (b), in the bonding step, the (100) or (111) surface of the diamond, into which the OH group was introduced in the first hydroxylation step, is brought into contact with this surface of the first base substrate, which has hydroxides of a given element M on its surface.

As shown in Fig. 5 (c), the contact part is dehydrated by applying activation energy. The dehydration energy may be thermal energy, light energy, electrical energy, or chemical energy. In the present embodiment, the contact part is heated. This dehydration leads to M-O-C bonding of at least some C atoms on the (100) or (111) surface of the diamond. Thus, the base second base substrate composed of diamond is bonded to the surface of the first base substrate. This bond has sufficient shear strength.

A method of manufacturing a diamond composite (first embodiment) can be modified to manufacture a diamond composite in which the first and second base substrates are bonded at the (110) surface of the diamond.

Specifically, one variant example of a method for manufacturing a diamond composite with bonding at the (110) surface of diamond is A method of manufacturing a diamond composite includes a first hydroxylation step of introducing OH groups to at least part of a surface of an oxide layer of a first base substrate having the oxide layer MOx of element M on the surface thereof and containing the element M in the composition, a second hydroxylation step of treating a (110) surface of a second base substrate composed of diamond with a mixture of ammonia and hydrogen peroxide to introduce OH groups to at least some C atoms of the (110) surface, a contact step of contacting the surface of the first base substrate into which the OH groups are introduced with the (110) surface of the diamond constituting the second base substrate into which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.

### (Method of Manufacturing Diamond Composite (Second Embodiment))

The manufacturing method of the diamond composite according to the second embodiment differs from the manufacturing method of the diamond composite according to the first embodiment in that the OH group is introduced into at least a part of the surface of the oxide layer of the first base substrate in the first hydroxylation step described above by immersion in a mixture of ammonia and hydrogen peroxide (NH₃/H₂O₂/H₂O) instead of oxygen plasma irradiation.

In the diamond composite with bonding at the (111) surface of diamond manufactured by this manufacturing method, the first base material that can be used in the diamond composite having bonding on the (100) surface of diamond (the diamond composite according to the present invention described above) can be used. In addition, in the diamond composite with bonding at the (111) surface of the diamond manufactured by this manufacturing method, at least some of the C atoms of the (111) surface of the diamond constituting the second base substrate are bonded to the oxide layer of the first base substrate by M-O-C bonding.

Fig. 6 (a) to Fig. 6 (c) are schematic perspective diagrams for explaining the bonding method between the first base substrate and the second base substrate made of diamond used in the method of manufacturing the diamond composite according to the second embodiment.

A method of manufacturing a diamond composite (second embodiment) can be modified to manufacture a diamond composite with bonding at the (110) surface of the diamond.

Specifically, another variant example of a method for manufacturing a diamond composite with bonding at the (110) surface of diamond is A method of manufacturing a diamond composite includes a first hydroxylation step of treating a surface of an oxide layer of a first base substrate having the oxide layer MOx of element M on the surface thereof and containing the element M in the composition with a mixture of ammonia and hydrogen peroxide to introduce OH groups to at least part of the surface, a second hydroxylation step of treating a (110) surface of a second base substrate composed of diamond with an oxidizing liquid to introduce OH groups to at least some C atoms of the (110) surface, a contact step of contacting the surface of the first base substrate to which the OH groups are introduced with the (110) surface of the diamond constituting the second base substrate to which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.

### (Method of Manufacturing Diamond Composite (Third Embodiment))

A method of manufacturing a diamond composite according to the third embodiment includes a first hydroxylation step of introducing OH groups to at least part of a surface of an oxide layer of a first base substrate having the oxide layer MOx of element M on the surface thereof and containing the element M in the composition, a second hydroxylation step of treating a surface of a second base substrate composed of polycrystalline diamond with a mixture of ammonia and hydrogen peroxide to introduce OH groups to at least some C atoms of the surface, a contact step of contacting the surface of the first base substrate into which the OH groups are introduced with the surface of the polycrystalline diamond constituting the second base substrate into which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.

The first hydroxylation step, the second hydroxylation step and the bonding step (surface-surface contact step and dehydration step) in this manufacturing method can be performed in the same manner as the first hydroxylation step, the second hydroxylation step and the bonding step (surface-surface contact step and dehydration step) in the method of manufacturing a diamond composite according to the first embodiment.

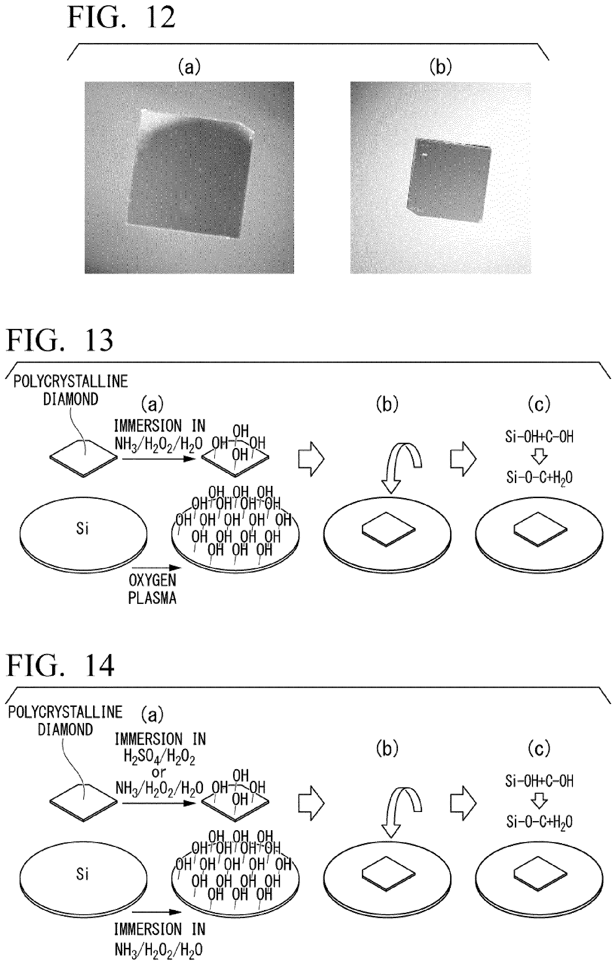

In Fig. 13, each process of the method of manufacturing the diamond composite according to the present embodiment is illustrated following Fig. 5. The only difference from the process shown in Fig. 5 is that the second base substrate used in this embodiment is polycrystalline diamond.

### <Method of Preparing Bonding Surface of Polycrystalline Diamond >

If necessary, the bonding surface of the polycrystalline diamond may be polished physically or chemically to increase the smoothness of the bonding surface. The surface smoothing of polycrystalline diamond substrates with a mixture of various crystal orientations is difficult by the conventional polishing method. Therefore, a metal surface plate made of, for example, iron or nickel, and an oxidizing agent such as hydrogen peroxide solution are used to refine and smooth short-lived oxidizing radicals near the contact point between the diamond and the metal surface plate.

### (Method of Manufacturing Diamond Composite (Fourth Embodiment))

A method of manufacturing a diamond composite according to the fourth embodiment includes a first hydroxylation step of treating a surface of an oxide layer of a first base substrate having the oxide layer MOx of element M on the surface thereof and containing the element M in the composition with a mixture of ammonia and hydrogen peroxide to introduce OH groups to at least part of the surface, a second hydroxylation step of treating a surface of a second base substrate composed of polycrystalline diamond with a mixture of ammonia and hydrogen peroxide to introduce OH groups to at least some C atoms of the surface, a contact step of contacting the surface of the first base substrate into which the OH groups are introduced with the surface of the polycrystalline diamond constituting the second base substrate into which the OH groups are introduced, and a dehydration step of imparting activation energy to the contacted first and second base substrates to undergo dehydration, wherein the M is one or more selected from a metal element (where alkali metals and alkaline earth metals are excluded) with which an oxide can be formed, Si, Ge, As, Se, Sb, Te, and Bi.

The first hydroxylation step, the second hydroxylation step and the bonding step (surface-surface contact step and dehydration step) in this manufacturing method can be performed in the same manner as the first hydroxylation step, the second hydroxylation step and the bonding step (surface-surface contact step and dehydration step) in the method of manufacturing a diamond composite according to the second embodiment.

In Fig. 14, each process of the method of manufacturing the diamond composite according to the present embodiment is illustrated following Fig. 6. The only difference from the process shown in Fig. 6 is that the second base substrate used in this embodiment is polycrystalline diamond.

### EXAMPLES

### <1. Diamond Composite with a (100) surface of Diamond As Bonding Surface >

### (1) Fabrication of diamond composite

### (Example 1)

A diamond substrate (EDP, Co., Ltd. 5mm x 5imn) with a (100) surface was immersed in a mixture of 10 mL of 28% ammonia solution, 10 mL of 35% hydrogen peroxide solution and 50 mL of pure water at a temperature of 75 °C for 10 minutes.

The SiO₂ film surface of a single crystal Si substrate (Matsuzaki Seisakusho, Co., Ltd. T4 APX, diameter 100mm) with a 1 nm-thick native oxide film on the surface thereof was treated with high-purity oxygen plasma at a pressure of 60 Pa and an output power of 200 W for 30 seconds. The plasma-treated SiO₂ film of the Si substrate, i.e., the surface of the Si substrate with Si-OH (first base substrate) and the (100) surface of the diamond substrate (second base substrate) were brought into contact in air and stored in a sealed container with a desiccant for three days.

Then, the diamond composite was obtained by heating at a temperature of 250 °C for 24 hours.

### (Example 2)

The diamond composite was obtained under the same conditions as in Example 1 except that the temperature at which the diamond substrate with the (100) surface was immersed in the mixture was at room temperature.

### (Comparative Example 1)

The diamond composite was obtained under the same conditions as in Example 1 except that the mixture in which the diamond substrate with a (100) surface was immersed was a mixture consisting of 20 mL of 98% sulfuric acid and 5 mL of 35% hydrogen peroxide solution.

### (2) Evaluation of diamond composite

Newton ring observations and shear strength measurements were performed.

Fig. 7 shows the results of Newton ring observation for the diamond composites obtained in Examples 1, 2 and Comparative Example 1. Figs. 7 (a) - 7 (c) show the results of Example 1, Example 2, and Comparative Example 1, respectively.

In both Fig. 7 (a) and Fig. 7 (b), it can be seen that the Newton rings are not observed and almost entire surfaces of diamond composites are bonded.

The shear strengths were 8.93 kgf (= 87.5 N) and 9.14 kgf (= 89.6 N), respectively. Since the size of the substrate is 5 mm by 5 mm, these strengths correspond to 3.50 MPa and 3.58 MPa, respectively, in terms of size per unit area (cm²).

On the other hand, in Fig. 7 (c), Newton rings are observed throughout, indicating that they are not bonded. Shear strength measurements showed less than 0.2 kgf (= 1.96 N). Because the size of the substrate is 5 mm by 5 mm, this strength corresponds to less than 0.078 MPa.

As described above, in Comparative Example 1, the shear strength was less than 0.1 MPa, while in Examples 1 and 2, the shear strength was more than 1 MPa. The shear strength is preferably 2 MPa or more, more preferably 3 MPa or more, and more preferably 3.5 MPa or more, as in Examples 1 and 2.

### <2. Comparison of the Case in which Mixture of Ammonia and Hydrogen Peroxide (NH₃/H₂O₂/H₂O) was used and the Case in which Mixture of Sulfuric Acid and Hydrogen Peroxide (H₂SO₄/H₂O₂) was used, in the Second Hydroxylation Step >

### (Experimental Example 1: case in which a mixture of ammonia and hydrogen peroxide was used)

The diamond composite for Experimental Example 1 was obtained as follows.

A diamond substrate (EDP, Co., Ltd. 3mm x 3mm) with a (111) surface was immersed in a mixture of 10 mL of 28% ammonia solution, 10 mL of 35% hydrogen peroxide solution and 50 mL of pure water at a temperature of 75 °C for 10 minutes.

The SiO₂ film surface of a single crystal Si substrate (Matsuzaki Seisakusho, Co., Ltd. T4 APX, diameter 100 mm) with a 300 nm-thick thermal oxide film on the surface thereof was treated with high-purity oxygen plasma at a pressure of 60 Pa and an output power of 200 W for 30 seconds.

The plasma-treated SiO₂ film of the Si substrate, i.e., the surface of the Si substrate with Si-OH and the (111) surface of the diamond substrate were brought into contact in air and stored in a sealed container with a desiccant for three days.

Then, the diamond composite was obtained by heating at a temperature of 200 °C for 24 hours.

### (Experimental Example 2: case in which a mixture of sulfuric acid and hydrogen peroxide was used)

The diamond composite for Experimental Example 2 was obtained under the same conditions as in Experimental Example 1 except that a mixture of 20 mL of 98% sulfuric acid and 5 mL of 35% hydrogen peroxide solution at a temperature of 75 °C was used.

### (Experimental Example 3: case in which a mixture of ammonia and hydrogen peroxide was used after treatment with a mixture of sulfuric acid and hydrogen peroxide)

A diamond composite for experimental example 3 was obtained under the same conditions as Experimental Example 1 except that a diamond substrate (EDP, Co., Ltd. 3mm x 3mm) with a (111) surface was immersed for 10 minutes in a mixture of 20 mL of 98% sulfuric acid and 5 mL of 35% hydrogen peroxide water at a temperature of 75 °C, and then immersed for 10 minutes in a mixture of 10 mL of 28% ammonia solution, 10 mL of 35% hydrogen peroxide water and 50 mL of pure water at a temperature of 75 °C.

Newton ring observations and shear strength measurements were performed on the diamond composites obtained in Experimental Examples 1 and 2.

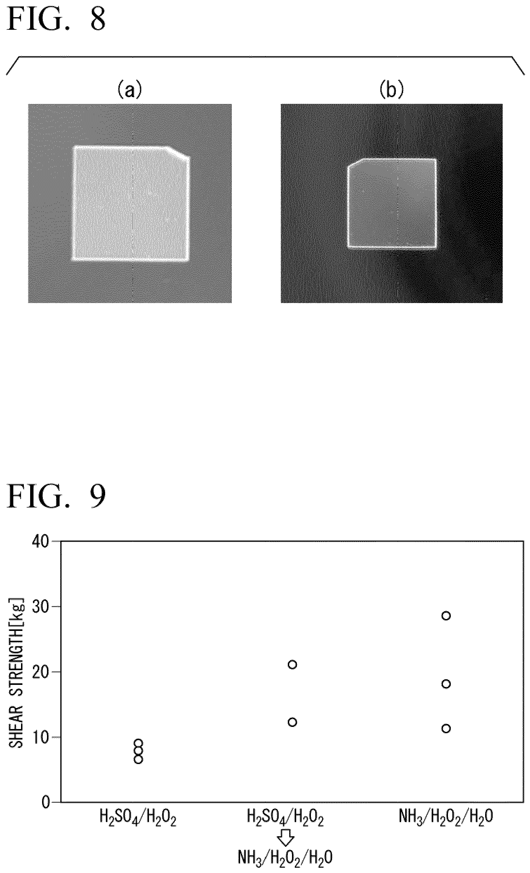

Fig. 8 shows the results of Newton ring observation for the diamond composites obtained in Experimental Examples 1 and 2. Figs. 8 (a) shows the result of Experimental Example 1, and Figs. 8 (b) shows the result of Experimental Example 2.

In both Fig. 8 (a) and Fig. 7 (b), it can be seen that the Newton rings are not observed and almost entire surfaces of diamond composites are bonded.

Fig. 9 shows the results of shear strength measurements on the diamond composites obtained in Experimental Examples 1 to 3.

Three samples were measured for Experimental Experiments 1 and 2, and two samples were measured for Experimental Experiment 3.

From the results shown in Fig. 9, the shear strengths were 11 ~ 28 kgf (= 107.8 ~ 274.4 N), 7 ~ 10 kgf (= 68.6 ~ 98.0 N), and 11 ~ 22 kgf (= 107.8 - 215.6 N) in the order of Experimental Examples 1 to 3. Since the size of the substrate is 3 mm by 3 mm, these strengths correspond to 12.00 ~ 30.49 MPa, 7.62 ~ 10.89 MPa and 12.00 ~ 23.95 MPa, respectively.

A mixture of ammonia and hydrogen peroxide improved shear strength.

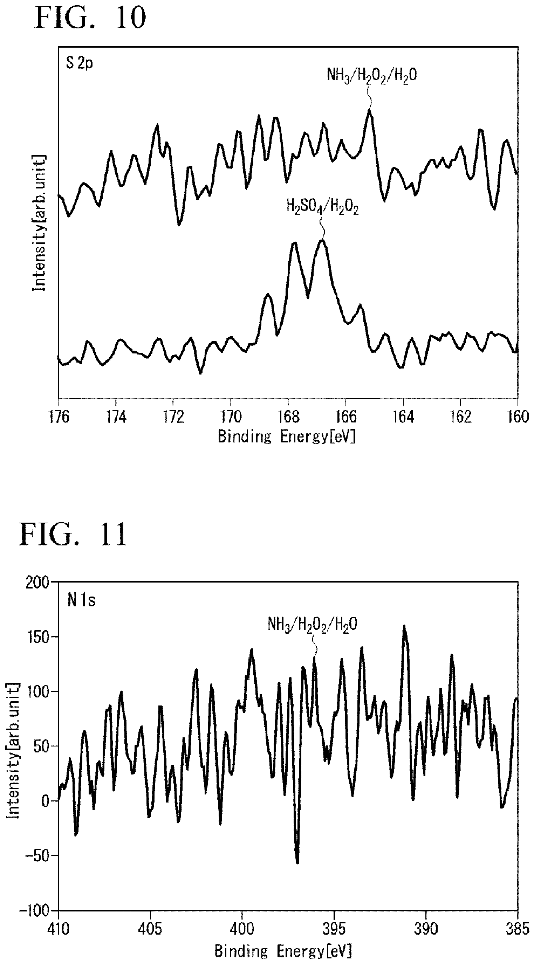

Fig. 10 shows the results of XPS measurements in the vicinity of S₂ₚ energy for the (111) surface of the diamond substrate after treatment with a mixture of ammonia and hydrogen peroxide in Experimental Example 1, and the results of XPS measurements in the vicinity of S₂ₚ energy for the (111) surface of the diamond substrate after treatment with a mixture of sulfuric acid and hydrogen peroxide in Experimental Example 2. Fig. 11 also shows the results of XPS measurements near the N₁ₛ energy for Experimental Example 1.

In the XPS spectrum of Experimental Example 2, a peak showing the presence of sulfur oxides appeared near the S₂ₚ energy, indicating that sulfur (S) compounds remained on the (111) surface of the diamond substrate. This residue is thought to inhibit the bond. On the other hand, in the XPS spectrum of Experimental Example 1, there was no peak near the Nis energy, and no residue of ammonia was detected.

The reason why the shear strength in the case which a mixture of ammonia and hydrogen peroxide was used was higher than that in the case which a mixture of sulfuric acid and hydrogen peroxide was used was probably due to the absence of sulfur compounds on the surface.

In addition, the reason why the diamond composite of Comparative Example 1 was not bonded is considered as follows. A smaller proportion of OH groups are formed when bonding at the (100) surface of the diamond substrate, and the effect of inhibition of bonding by sulfur oxide is larger than when bonding at the (111) surface of the diamond substrate.

### <3. Comparison of the Case in which First Base Substrate was treated with Mixture of Ammonia and Hydrogen Peroxide and the Case in which First Base Substrate was irradiated with Oxygen Plasma, in the First Hydroxylation Step >

### (Experimental Example 4: case in which treated with a mixture of ammonia and hydrogen peroxide)

The diamond composite for Experimental Example 4 was obtained as follows.

A diamond substrate (EDP, Co., Ltd. 3mm x 3mm) with a (111) surface was immersed in a mixture of 10 mL of 28% ammonia solution, 10 mL of 35% hydrogen peroxide solution and 50 mL of pure water at a temperature of 75 °C for 10 minutes.

A single crystal Si substrate (Matsuzaki Seisakusho, Co., Ltd. T4 APX, diameter 100mm) with a 1 nm-thick natural oxide film on the surface thereof was immersed in a mixture of 10 mL of 28% ammonia solution, 10 mL of 35% hydrogen peroxide solution and 50 mL of pure water at room temperature for 10 minutes.

The SiO₂ film of the immersed Si substrate, i.e., the surface of the Si substrate with Si-OH and the (111) surface of the diamond substrate were brought into contact in air and stored in a sealed container with a desiccant for three days.

Then, the diamond composite was obtained by heating at a temperature of 200 °C for 24 hours.

### (Experimental Example 5: case in which irradiated with oxygen plasma)

A diamond substrate (EDP, Co., Ltd. 3mm x 3mm) with a (111) surface was immersed in a mixture of 10 mL of 28% ammonia solution, 10 mL of 35% hydrogen peroxide solution and 50 mL of pure water at a temperature of 75 °C for 10 minutes.

The SiO₂ film surface of a single crystal Si substrate (Matsuzaki Seisakusho, Co., Ltd. T4 APX, diameter 100mm) with a 1 nm-thick native oxide film on the surface thereof was treated with high-purity oxygen plasma at a pressure of 60 Pa and an output power of 200 W for 30 seconds.

The plasma-treated SiO₂ film of the Si substrate, i.e., the surface of the Si substrate with Si-OH and the (111) surface of the diamond substrate were brought into contact in air and stored in a sealed container with a desiccant for three days.

Then, the diamond composite was obtained by heating at a temperature of 250 °C for 24 hours.

Fig. 12 shows the results of Newton ring observation for the diamond composites obtained in Experimental Examples 4 and 5. Figs. 12 (a) and (b) show the results of Examples 4 and 5, respectively.

In both Fig. 12 (a) and Fig. 12 (b), it can be seen that the Newton rings are not observed and almost entire surfaces of diamond composites are well bonded.

The shear strengths were 10 kgf (= 98 N) and 18 kgf (= 176.4 N), respectively. Since the size of the substrate is 3 mm by 3 mm, these strengths correspond to 10.89 MPa and 19.6 MPa, respectively.

In the first hydroxylation step, it was found that sufficient bonding can be obtained even if treatment with a mixture of ammonia and hydrogen peroxide is used without using oxygen plasma irradiation. In this case, the first hydroxylation step can be simplified compared with the case of using oxygen plasma irradiation.

### <4. Diamond Composite in which the Surface of Polycrystalline Diamond is the Bonding Interface >

### (Example 3)

A polycrystalline diamond substrate was immersed in a mixture of 10 mL of 28% ammonia solution, 10 mL of 35% hydrogen peroxide solution and 50 mL of pure water at a temperature of 75 °C for 10 minutes. The polycrystalline diamond substrate was obtained by forming a polycrystalline diamond layer of about 0.5 mm thickness on the Si substrate by the CVD method and mechanically peeling the Si substrate. In addition, the surface of the polycrystalline diamond substrate, which is bonded to the first base substrate, was flattened by polishing with an oxidizing liquid.

The SiO₂ film surface of a single crystal Si substrate (Matsuzaki Seisakusho, Co., Ltd. T4 APX, diameter 100mm, thickness 0.4mm) with a 1 nm-thick native oxide film on the surface thereof was treated with high-purity oxygen plasma at a pressure of 60 Pa and an output power of 200 W for 30 seconds. The plasma-treated SiO₂ film of the Si substrate, i.e., the surface of the Si substrate with Si-OH (first base substrate) and the surface of the polycrystalline diamond substrate (second base substrate) were brought into contact in air and stored in a sealed container with a desiccant for three days.

Then, the diamond composite was obtained by heating at a temperature of 250 °C for 24 hours.

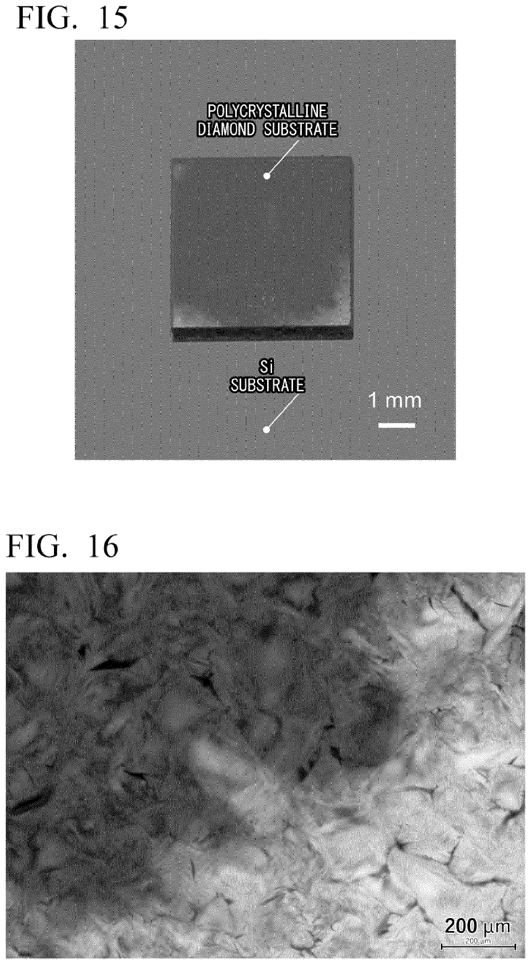

Newton ring observation was performed as an evaluation of the diamond composite in Example 3. Figure 15 shows the results.

No Newton rings were observed. It can be seen that good bonding can be obtained in almost the entire surface (more than 90%), although a non-bonded part due to the surface shape exists at the edge of the substrate (lower right in Fig. 15) and appears bright.

It should be noted that the Newton rings are not observed in the same way as in Examples 1 and 2, and good bonding can be obtained even when the temperature of immersing the polycrystalline diamond substrate in a mixture of ammonia and hydrogen peroxide is at room temperature.

Fig. 16 shows the results of optical microscopy of the non-bonded part (bottom right in Figure 15) of the diamond composite obtained in Example 3.

Microscopic images show that the grains, which are several 100 µm in size, are densely arranged on the surface.

Of the grains that make up the surface of polycrystalline diamond, those directly bonded to the Si substrate appear dark. On the other hand, grains that are not bonded and have gaps between the diamond substrate and the Si substrate appear brighter. This is because the reflection is different when there is a gap at the interface. This shows that the bonding are formed at the grain level.

### (Example 4)

A polycrystalline diamond substrate was immersed in a mixture of 10 mL of 28% ammonia solution, 10 mL of 35% hydrogen peroxide solution and 50 mL of pure water at a temperature of 75 °C for 10 minutes. The polycrystalline diamond substrate was obtained by forming a polycrystalline diamond layer of about 0.5 mm thickness on the Si substrate by the CVD method and mechanically peeling the Si substrate. In addition, the surface of the polycrystalline diamond substrate, which is bonded to the first base substrate, was flattened by polishing with an oxidizing liquid.

A TiO₂ surface prepared by sputtering a 20 nm-thick Ti film on the SiO₂ film surface of a single-crystal Si substrate (Matsuzaki Seisakusho, Co., Ltd. T4 APX, diameter 100mm, thickness 0.4mm) with a 1 nm-thick native oxide film on the surface was treated with high-purity oxygen plasma at a pressure of 60 Pa and an output power of 200 W for 30 seconds. The plasma-treated TiO₂ film of the Si substrate, i.e., the surface of the Si substrate with Ti-OH (first base substrate) and the surface of the polycrystalline diamond substrate (second base substrate) were brought into contact in air and stored in a sealed container with a desiccant for three days.

Then, the diamond composite was obtained by heating at a temperature of 250 °C for 24 hours.

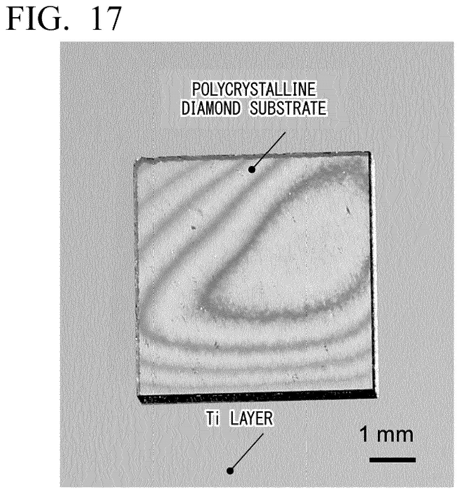

Newton ring observations was performed as an evaluation of the diamond composite obtained in Example 4. Fig. 17 shows the results.

Although Newton rings originating from non-bonded portions are visible in 60% or more parts of the bonding surface, Newton rings are not visible in other parts, indicating that good bonding is obtained. Example 4 is a preliminary example for determining whether or not good bonding can be obtained, and the bonding area can be expanded by applying surface smoothing treatment.

### DESCRIPTION OF THE REFERENCE SIGNS

10 first base substrate
10a oxide layer
20 second base substrate
100 diamond composite

## Claims

1. A diamond composite, comprising:
a first base substrate which has an oxide layer MOx of element M on the surface thereof and contains the element M in the composition; and
a second base substrate which is bonded to the oxide layer and is composed of diamond,
wherein the M is one or more selected from a metal element (where alkali metals and alkaline earth metals are excluded) with which an oxide can be formed, Si, Ge, As, Se, Sb, Te, and Bi, and the second base substrate is bonded to the oxide layer of the first base substrate by M-O-C bonding of at least some C atoms on the (100) surface of the diamond constituting the second base substrate.

2. The diamond composite according to claim 1, wherein the M is one or more selected from Si, Ti, Al, Cu, In and Ga.

3. The diamond composite according to claim 1 or 2, wherein the first base substrate is a heat sink or a heat spreader.

4. An electronic device, comprising the diamond composite according to claim 1 or 2, wherein the (100) surface of the diamond constituting the second base substrate is bonded to the oxide layer of the first base substrate, and an electronic element is formed on the other surface of the second base substrate, which is not bonded to first base substrate.

5. An electronic device, comprising the diamond composite according to claim 1 of 2, wherein the oxide layer of the first base substrate is bonded to the (100) surface of the diamond constituting the second base substrate, and an electronic element is formed on the other surface of the first base substrate, which is not bonded to second base substrate.

6. A diamond composite, comprising:
a first base substrate which has an oxide layer MOx of element M on the surface thereof and contains the element M in the composition; and
a second base substrate which is bonded to the oxide layer and is composed of polycrystalline diamond,
wherein the M is one or more selected from a metal element (where alkali metals and alkaline earth metals are excluded) with which an oxide can be formed, Si, Ge, As, Se, Sb, Te, and Bi, and the second base substrate is bonded to the oxide layer of the first base substrate by M-O-C bonding of at least some C atoms on the surface of the polycrystalline diamond constituting the second base substrate.

7. The diamond composite according to claim 6, wherein the M is one or more selected from Si, Ti, Al, Cu, In and Ga.

8. The diamond composite according to claim 6 or 7, wherein the first base substrate is a heat sink or a heat spreader.

9. An electronic device, comprising the diamond composite according to claim 6 or 7, wherein the surface of the polycrystalline diamond constituting the second base substrate is bonded to the oxide layer of the first base substrate, and an electronic element is formed on the other surface of the second base substrate, which is not bonded to first base substrate.

10. An electronic device, comprising the diamond composite according to claim 6 or 7, wherein the oxide layer of the first base substrate is bonded to the surface of the polycrystalline diamond constituting the second base substrate, and an electronic element is formed on the other surface of the first base substrate, which is not bonded to second base substrate.

11. A method for hydroxylating a surface of a base substrate composed of diamond, comprising: treating a (100) surface or a (111) surface of the base substrate composed of diamond with a mixture of ammonia and hydrogen peroxide to introduce OH groups to at least some C atoms of the (100) surface or the (111) surface.

12. A method for hydroxylating a surface of a base substrate composed of diamond, comprising: treating a surface of the polycrystalline diamond with a mixture of ammonia and hydrogen peroxide to introduce OH groups to at least some C atoms of the surface.

13. A method of manufacturing a diamond composite, comprising:
a first hydroxylation step of introducing OH groups to at least part of a surface of an oxide layer of a first base substrate having the oxide layer MOx of element M on the surface thereof and containing the element M in the composition;
a second hydroxylation step of treating a (100) surface or a (111) surface of a second base substrate composed of diamond with a mixture of ammonia and hydrogen peroxide to introduce OH groups to at least some C atoms of the (100) surface or the (111) surface;
a contact step of contacting the surface of the first base substrate into which the OH groups are introduced with the (100) surface or the (111) surface of the diamond constituting the second base substrate into which the OH groups are introduced; and
a dehydration step of imparting activation energy to the contacted first and second base substrates to undergo dehydration,
wherein the M is one or more selected from a metal element (where alkali metals and alkaline earth metals are excluded) with which an oxide can be formed, Si, Ge, As, Se, Sb, Te, and Bi.

14. A method of manufacturing a diamond composite, comprising:
a first hydroxylation step of introducing OH groups to at least part of a surface of an oxide layer of a first base substrate having the oxide layer MOx of element M on the surface thereof and containing the element M in the composition;
a second hydroxylation step of treating a surface of a second base substrate composed of polycrystalline diamond with a mixture of ammonia and hydrogen peroxide to introduce OH groups to at least some C atoms of the surface;
a contact step of contacting the surface of the first base substrate into which the OH groups are introduced with the surface of the polycrystalline diamond constituting the second base substrate into which the OH groups are introduced; and
a dehydration step of imparting activation energy to the contacted first and second base substrates to undergo dehydration,
wherein the M is one or more selected from a metal element (where alkali metals and alkaline earth metals are excluded) with which an oxide can be formed, Si, Ge, As, Se, Sb, Te, and Bi.

15. A method of manufacturing a diamond composite, comprising:
a first hydroxylation step of treating a surface of an oxide layer of a first base substrate having the oxide layer MOx of element M on the surface thereof and containing the element M in the composition with a mixture of ammonia and hydrogen peroxide to introduce OH groups to at least part of the surface;
a second hydroxylation step of treating a (100) surface or a (111) surface of a second base substrate composed of diamond with an oxidizing liquid to introduce OH groups to at least some C atoms of the (100) surface or the (111) surface;
a contact step of contacting the surface of the first base substrate into which the OH groups are introduced with the (100) surface or the (111) surface of the diamond constituting the second base substrate into which the OH groups are introduced; and
a dehydration step of imparting activation energy to the contacted first and second base substrates to undergo dehydration,
wherein the M is one or more selected from a metal element (where alkali metals and alkaline earth metals are excluded) with which an oxide can be formed, Si, Ge, As, Se, Sb, Te, and Bi.

16. A method of manufacturing a diamond composite, comprising:
a first hydroxylation step of treating a surface of an oxide layer of a first base substrate having the oxide layer MOx of element M on the surface thereof and containing the element M in the composition with a mixture of ammonia and hydrogen peroxide to introduce OH groups to at least part of the surface;
a second hydroxylation step of treating a surface of a second base substrate composed of polycrystalline diamond with an oxidizing liquid to introduce OH groups to at least some C atoms of the surface;
a contact step of contacting the surface of the first base substrate into which the OH groups are introduced with the surface of the polycrystalline diamond constituting the second base substrate into which the OH groups are introduced; and
a dehydration step of imparting activation energy to the contacted first and second base substrates to undergo dehydration,
wherein the M is one or more selected from a metal element (where alkali metals and alkaline earth metals are excluded) with which an oxide can be formed, Si, Ge, As, Se, Sb, Te, and Bi.
